# EUROPEAN PATENT SPECIFICATION

(11) **EP 0 996 318 B1**
(45) Date of publication and mention of the grant of the patent: **19.04.2006**
(21) Application number: 99308239.5
(22) Date of filing: 19.10.1999
(51) Int. Cl.: H05K 3/02, H05K 3/38

(54) **Novel composite foil, process for producing the same and copper-clad laminate**
Neue Verbundfolie, Verfahren zu deren Herstellung und Kupferkaschiertes Laminat
Nouvelle feuille composite, procédé de sa production et laminé revêtu de cuivre

(30) Priority: 19.10.1998 JP 29739998; 21.10.1998 JP 31841998
(43) Date of publication of application: 26.04.2000
(73) Proprietor: MITSUI MINING & SMELTING CO., LTD., Tokyo 141-8584 (JP)
(72) Inventor: Kataoka, Takashi, Ageo-shi, Saitama 362-0021 (JP); Hirasawa, Yutaka, Okegawa-shi, Saitama 363-0026 (JP); Yamamoto, Takuya, Ageo-shi, Saitama 362-0014 (JP); Iwakiri, Kenichiro, Ageo-shi, Saitama 362-0021 (JP); Higuchi, Tsutomu, Ageo-shi, Saitama 362-0021 (JP)
(74) Representative: Calamita, Roberto

(56) References cited:
- EP-A- 0 297 678
- EP-A- 0 398 721
- GB-A- 1 462 001
- GB-A- 2 012 307
- US-A- 3 281 339
- US-A- 3 984 598
- US-A- 3 998 601
- US-A- 4 088 544

## Description

The present invention relates generally to a composite foil for use in the production of a printed wiring board and to a process for producing the composite foil. More particularly, the invention relates to a composite foil for printed wiring board production, with which the laser perforating of a copper-clad laminate produced from the composite foil can be carried out without forming burrs even at lower laser power. Meantime, the copper-clad laminate makes possible a fine-pitch printed wiring board.

Recently, the pattern widths and spacings of printed wiring (i.e. circuit) boards have been densificated year by year in accordance with the down sizing of electronic equipment. Accordingly, the thickness of metal foils for such application should be decreased from 18 µm or 12 µm to 9 µm.

Reduction of the foil thickness is necessary, and trials of producing ultra-thin copper foils have been made in order to cope with the demand. However, copper foils with a thickness of 9 µm or less are likely to wrinkle or tear in processing, and fully satisfactory ultra-thin copper foils have not been obtained.

Further, the ultra-thin copper foil, when employed as an outer layer of a multilayer printed wiring board, encounters problems of breakage (tear) or wrinkling attributed to the deformation of the copper foil, caused by the inner wiring patterns during hot pressing, so that a peelable carrier capable of preventing the deformation of the copper foil is inevitably required.

A copper foil with the peelable carrier is generally furnished with a release layer which is placed between the copper foil and the carrier, because only the carrier is stripped off after the lamination. For example, when a copper carrier is employed, chromate as a release layer has been proposed (see, for example, Japanese Patent Application Publication (Examined) No. Sho 53-18329).

When an aluminum carrier is employed, some release layers shown below have been proposed.
A layer composed of a sulfide or oxide of Cr, Pb, Ni or Ag;
A layer of Ni or Ni alloy plating formed after zinc substitution; or
A layer of aluminum oxide coating formed again after the removal of surface oxides (see Japanese Patent Application Publication (Examined) No. Sho 60-31915).

Still further, the inventors have proposed a composite foil comprising a metal carrier and an ultra-thin copper foil of 20 µm or less thickness having an organic release layer interposed therebetween.

However, when the copper-clad laminate produced from the above conventional composite foils is perforated to form via holes, burrs might be found at edges of the perforated copper foil. Plating growth at the burrs is faster than at the flat portions of the copper foil, so that the burrs are enlarged to thereby cause problems of poor adhesion with an etching resist. Accordingly, it is preferred to remove the copper foil at the portions to be perforated by, for example, etching in advance. However, this means that an additional step is required in the perforation. Moreover, when the copper foil is ultra-thin, the removal of burrs by etching has caused undesirable thinning of the copper foil itself.

Document US-A-4 088 544 discloses a composite foil comprising a thin copper foil covered by a layer of copper particles.

In these circumstances, the inventors have conducted extensive and intensive studies. As a result, it has been found that the formation of a copper-clad laminate by providing a composite foil comprising a conductive particle layer deposited on an organic release layer coating a carrier, for example, a copper foil or copper alloy foil, laminating a substrate with this composite foil and stripping off the carrier enables forming an upper-layer wiring pattern from the conductive particle layer to thereby solve the problem of burr occurrence, etc. at the perforating of the copper-clad laminate. Furthermore, it has been found that the conductive particle layer has excellent adhesion with resin. The present invention has been completed on the basis of these findings.

The present invention has been made with a view toward solving the above problems of the prior art. Accordingly, an object of the present invention is to provide a composite foil for printed wiring board production, with which the laser perforating of a copper-clad laminate produced from the composite foil can be carried out without forming burrs even at lower laser power. Meantime the copper-clad laminate makes possible fine pitch wiring patterns. Another object is to provide a process for producing the composite foil for printed wiring board production.

The composite foil of the present invention comprises:
a conductive carrier,
an organic release layer coating a surface of the carrier, and
a conductive particle layer formed on the organic release layer.

The conductive particle layer preferably has a thickness ranging from 0.1 to 5.0 µm.

Further, the conductive particle layer is preferably composed of copper or a copper alloy.

It is preferred that the carrier be a copper foil or a copper alloy foil.

The organic release layer is preferably composed of at least one organic compound selected from the group consisting of nitrogen-containing compounds, sulfur-containing compounds and carboxylic acids.

It is preferred that the conductive particle layer be composed of fringed, nodular or whiskery conductive fine particles.

The process for producing a composite foil according to the present invention comprises the steps of:
forming an organic release layer on a carrier surface, and
electrodepositing a conductive particle layer on the organic release layer with the use of a plating bath through which current is passed at a density of 10 to 50 A/dm².

The carrier is preferably a copper foil or a copper alloy foil. The organic release layer is preferably composed of at least one organic compound selected from the group consisting of nitrogen-containing compounds, sulfur-containing compounds and carboxylic acids.

It is preferred that the conductive particle layer be composed of particles having a shape of fringed, nodular or whiskery.

The copper-clad laminate of the present invention comprises the above composite foil laminated with an insulating resin substrate.

Further, the copper-clad laminate of the present invention may comprise the above composite foil laminated with an insulating resin substrate, having only the carrier removed therefrom.

In the accompanying drawings:
Fig. 1 shows a schematic sectional view of an embodiment of the composite foil of the present invention;
Fig. 2 shows a panel plating process for producing a printed wiring board, in which an embodiment of the composite foil of the present invention is used;
Fig. 3 shows a pattern plating process for producing a printed wiring board, in which an embodiment of the composite foil of the present invention is used.

Hereinafter, the novel composite foil of the present invention and the process for preparing the same will be described in detail.

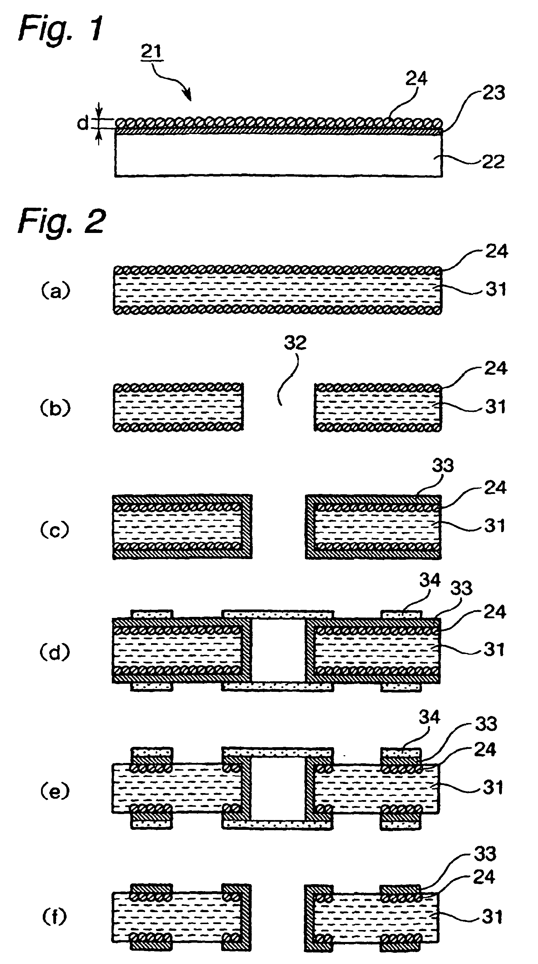

Fig. 1 shows a schematic sectional view of an embodiment of the novel composite foil according to the present invention. In the embodiment, the composite foil 21 comprises a carrier 22, an organic release layer 23 superimposed on a surface of the carrier, and conductive particle layer 24 peelably formed on surface of the organic release layer.

The conductive carrier is not limited, for example, in its material, thickness, etc., when it is conductive and can form thereon the conductive particle layer. Such carrier 22 can be selected from various materials and preferably a metal foil including a copper foil, a copper alloy foil, an aluminum foil, a copper-plated aluminum foil, a zinc-plated aluminum foil and a stainless steel foil. Of these, the copper foil and the copper alloy foil are especially preferred.

The conductive carrier may be passivated with, for example, zinc and chromate.

It is preferred that the thickness of the conductive carrier 22 be in the range of 5 to 200 µm, preferably 12 to 110 µm, and especially 18 to 70 µm.

Although the organic release layer 23 is not particularly limited as long as it has release capability, it is preferred that the organic release layer 23 be composed of at least one organic compound selected from the group consisting of nitrogen-containing compounds, sulfur-containing compounds and carboxylic acids.

Examples of the nitrogen-containing compounds include triazole having a substituent (functional group), such as 1,2,3-benzotriazole, carboxybenzotriazole, N,N'-bis(benzotriazolylmethyl)urea and 3-amino-1H-1,2,4-triazole. Examples of the sulfur-containing compounds include mercaptobenzothiazole, thiocyanuric acid and 2-benzimidazolthiol.

Examples of carboxylic acids include monocarboxylic acids such as oleic acid, linolic acid and linolenic acid.

It is generally preferred that the thickness of the organic release layer 23 be in the range of 10 to 1000 Å, especially 20 to 500 Å (1Å = 1.10⁻¹⁰ m).

Conductive fine particles constituting the conductive particle layer 24 deposited on the surface of the organic release layer 23 are not particularly limited as long as they are conductive. Examples thereof include:
metals such as copper, silver, gold, platinum, zinc and nickel and alloys of the metals;
inorganic compounds such as iridium oxide and tin oxide; and
organic compounds such as polyaniline.

It is preferred that the conductive fine particles be composed of copper or a copper alloy among the above.

The conductive particle layer 24 may be composed of conductive fine particles of a single species selected from among the above, or fine particles of a mixture of at least two species of conductive substances.

The thickness (d), dimension in the direction of the thickness of the composite foil, of the conductive particle layer 24 is preferably in the range of 0.1 to 5.0 *µ*m, still preferably 0.2 to 3.0 *µ*m, yet still preferably 0.2 to 2.0 *µ*m, and optimally 0.5 to 1.0 *µ*m.

The thickness (d) can be measured by using a micrometer or a sectional view of the composite foil by optical microscope and/or SEM (Scanning Electron Microscope).

Although the configuration of the conductive particle layer 24 is not particularly limited, it is preferred that the conductive particles constituting the conductive particle layer 24 be fringed, nodular or whiskery. For example, the conductive particle layer 24 is preferably composed of a fringed aggregate of primary particles with a size of about 0.1 to 3.0 *µ*m.

The conductive particle layer 24 is preferably formed on the organic release layer at a density of 2 to 10 g/m², still preferably 4 to 8 g/m². It is preferred that least some of conductive fine particles are not joined to the other conductive fine particles. Thus, the conductive particle layer 24 may have conductive fine particles, or aggregates of conductive fine particles separated from each other. Thus, the conductive particle layer is not like a film or foil which can be separated as a continuous layer.

In the present invention, the conductive particle layer 24 may have its surface plated with a covering layer. When the covering layer is provided, the thickness by weight (i.e., gravimetric thickness) thereof, in terms of the sum of the conductive particle layer and the covering layer, is preferably up to 5.0 µm, still preferably 0.1 to 3.0 *µ*m, yet still preferably 0.2 to 3.0 *µ*m, and optimally 0.5 to 1.0 *µ*m. In the present invention, the covering layer may be provided on the surface of the organic release layer not electrodeposited with the conductive particle layer.

As shown in Comparative Example 1, an initial layer of copper which directly formed on the release layer cannot be too thick, since it will interfere with laser drilling. The thickness by weight (i.e., gravimetric thickness) of such covering layer should be, in terms of the sum of the conductive particle layer and the covering layer, up to 5.0 *µ*m, preferably 0.1 to 3.0 *µ*m, more preferably 0.2 to 3.0 *µ*m, and especially 0.5 to 1.0 *µ*m.

Although the covering layer is not particularly limited, it is preferred that, like the conductive particle layer, the covering plating layer be composed of copper or a copper foil.

When the covering layer is provided on the surface of the conductive particle layer, the adhesion between the conductive particle layer and the organic release layer can be enhanced. Accordingly, in the bonding of a copper-clad laminate to a base material resin, the conductive fine particles are not buried in the base material resin by the heat and pressure applied in producing printed wiring boards.

Although the covering layer is preferred, it may be omitted, as in Example 2, when the shape and size of the deposited particles are such that they are not buried in the base resin during lamination.

In the composite foil of the present invention, the conductive particle layer 24 has a surface whose surface roughness (Rz) is preferably in the range of 0.5 to 10.0 *µ*m, still preferably 1.0 to 5.0 *µ*m, and yet still preferably 2.0 to 4.5 *µ*m. The surface roughness recited in the present invention is measured in accordance with the method of JIS C 6515 or IPC TM 650.

Further, in the composite foil of the present invention, it is preferred that the peel strength from carrier as measured in accordance with JIS C 6481 be in the range of 1 to 200N/m (1 to 200 gf/cm), practically 5 to 100 N/m (5 to 100 gf/cm). When the peel strength of the composite foil falls within the above range, the conductive carrier can easily be removed from the composite foil after forming a copper-clad laminate from the composite foil of the present invention.

In the composite foil of the present invention, combinations of conductive fine particles and conductive carrier are, for example, as specified in the following Table 1.

**Table 1**

| | | |
|---|---|---|
| conductive fine particles | | carrier |
| copper fine particles | | copper foil |
| copper fine particles | | copper alloy foil |
| copper fine particles | | aluminum foil |
| copper fine particles | | aluminum foil having its surface plated with copper |
| copper alloy fine particles | | copper foil |
| copper alloy fine particles | | copper alloy foil |
| copper alloy fine particles | | aluminum foil having its surface plated with copper |

The production of a copper-clad laminate from the above composite foil of the present invention enables:
laser perforating the copper-clad laminate without the occurrence of burrs even at lower laser output, and
obtaining a printed wiring board or multilayer printed wiring board having fine-pitch patterns.

### Process for producing composite foil

The process for producing a composite foil according to the present invention will now be described.

In the present invention, first, an organic release layer is formed on a surface of a conductive carrier.

The conductive carrier for use in the process is the same as described hereinbefore. It is preferably composed of copper or a copper foil.

Prior to the formation of the organic release layer, the carrier surface may be washed with a pickling liquid or water in order to remove oxide films therefrom.

The organic release layer, as aforementioned, is preferably composed of at least one organic compound selected from the group consisting of the nitrogen-containing compounds, the sulfur-containing compounds and the carboxylic acids. Although the method of forming the organic release layer on the carrier surface is not particularly limited as long as a uniform organic release layer can be formed on the carrier surface, the organic release layer is generally formed by the immersion method or coating method. For example, when the organic release layer is formed by the immersion method, the carrier is immersed in an aqueous solution of an organic compound capable of forming an organic release layer, such as triazole, to thereby form the organic release layer. The concentration of organic compound in the aqueous solution may be, for example, in the range of 0.01 to 1% by weight and the immersion time may be in the range of 5 to 60 sec. Although the effects of the present invention are not lessened by an increase of concentration or a prolongation of immersion time, falling within the above ranges is preferred from the viewpoint of cost and productivity.

The organic release layer superimposed on the conductive carrier is electrodeposited with conductive fine particles by performing cathodic electrolysis in a plating bath. The current density applied is appropriately selected depending on the composition of the bath. For example, cathodic electrolysis is performed at a current density of 1 to 50 A/dm². The plating bath is, for example, selected from among a copper pyrophosphate plating bath, a copper cyanide plating bath and an acid copper sulfate plating bath. An acid copper sulfate plating bath and a copper pyrophosphate plating bath are preferred.

When the electrodeposition of conductive particles is performed with the use of an acid copper sulfate plating bath, preferred use is made of a copper sulfate plating bath whose copper concentration is in the range of 5 to 60 g/liter and whose sulfuric acid concentration is in the range of 50 to 200 g/liter. The plating period is preferably in the range of 5 to 20 sec. Although the conductive particles can be obtained even if the copper concentration falls outside the above range, the copper concentration of less than 5 g/liter may cause uneven electroplating and the copper concentration of greater than 60 g/liter necessitates an increase of current density which may be economiccally disadvantageous. It is generally preferred that the temperature of the plating bath be in the range of 15 to 40°C.

The above copper sulfate plating bath, may be doped as desired with 0.5 to 20 ppm of one or more additives, such as α-naphthoquinoline, dextrin, glue, PVA, triethanolamine and thiourea. The additives enable controlling the configuration of the primary particles constituting the conductive particle layer.

In the present invention, after the formation of an electrodeposit on the organic release layer coated on the conductive carrier, the electrodeposit may further be electroplated so that the conductive particles are plated with a covering layer.

Although the electroplating conditions are not particularly limited, it is generally preferred to employ a copper sulfate plating bath whose copper concentration, sulfuric acid concentration and temperature are 50 to 80 g/liter, 50 to 150 g/liter and 40 to 50°C, respectively. The current density is preferably in the range of 10 to 50 A/dm², and the plating period is preferably in the range of 5 to 60 sec.

The covering layer can also be formed by the use of a copper pyrophosphate plating bath. Although the plating conditions therefor are not particularly limited, it is preferred that the copper concentration and the potassium pyrophosphate concentration be in the range of 10 to 50 g/liter and 100 to 700 g/liter, respectively. The pH of the electrolytic solution is preferably in the range of 8 to 12, and the current density is preferably in the range of 3 to 15 A/dm². The plating period is preferably in the range of 3 to 80 sec. With respect to the covering layer, the organic release layer surface not electrodeposited with the conductive particles may be furnished with the covering plating layer.

When the covering layer is provided, in the bonding of a copper-clad laminate to a base material resin, conductive fine particles are not buried in the base material resin by the heat and pressure applied in producing the printed wiring board.

The thus obtained composite foil may further be passivated. The passivation can be performed by conventional methods such as those using zinc and a chromate.

### Laminate and printed wiring board

The copper-clad laminate of the present invention can be produced from the above composite foil of the present invention.

Specifically, the copper-clad laminate can be obtained by bonding the above composite foil to an insulating resin substrate so that the conductive particle layer faces the insulating resin substrate.

The insulating resin substrate is not particularly limited and is, for example, composed of composite base materials such as glass epoxy, glass polyimide, glass polyester, aramide epoxy, FR-4, paper-phenolic and paper-epoxy base materials.

It is preferred that the bonding of the composite foil to the insulating resin substrate be performed at 155 to 230°C under a pressure of 1.5x15 MPa (15 to 150 kgf/cm²).

In the laminate of the present invention, only the conductive carrier may be removed therefrom after the bonding of the conductive particulate mass of the composite foil to the insulating resin substrate.

In the present invention, a structure obtained by bonding the composite foil to the insulating resin substrate may be referred to as "laminate with carrier", and a structure obtained by removing the conductive carrier from the laminate with carrier may be referred to as "laminate without carrier".

When the conductive carrier is stripped from the copper-clad laminate, the copper-clad laminate without carrier consists of the conductive particle layer and the insulating resin substrate (in the present invention, this copper-clad laminate without carrier may be simply referred to as "copper-clad laminate") can be obtained. With respect to the thus obtained copper-clad laminate without carrier, when laser perforating for producing via holes is performed to the conductive particle layer, burrs do not occur at the via hole edges, in contrast to the conventional copper-clad laminates whose outer layers are composed of copper foils. Moreover, the perforating of the conductive particle layer can be accomplished with the use of laser of lower output than that used to perforate conventional copper foil.

The method of producing the printed wiring board of the present invention is not particularly limited. For example, the panel plating process or the pattern plating process can be employed.

In the panel plating process, the printed wiring board is produced through, for example, the process shown in Fig. 2. Specifically, referring first to Fig. 2(a), the above composite foil is bonded to an insulating resin substrate 31, and only the conductive carrier is removed to obtain a laminate having its surface furnished with the conductive particle layers 24. Subsequently, referring to Fig. 2(b), the laminate having its surface furnished with the conductive particle layers 24 is perforated by laser irradiation to thereby form a via hole 32. The surface defining the via hole 32 and the surface of the insulating resin layer 31 are subjected to electroless plating and electroplating to thereby form plating layers 33 as shown in Fig. 2(c). Referring now to Fig. 2(d), resists 34 are provided on surfaces of the plating layers 33 so as to have patterns corresponding to wiring patterns to be formed. Referring to Fig. 2(e), at portions on which no wiring patterns to be formed, the plating layers 33 are removed by etching. Thereafter, the resists are removed to thereby obtain wiring patterns 33, as shown in Fig. 2(f).

In the printed wiring board of the present invention, the conductive fine particles of the composite foil are provided on a surface of insulating resin layer to thereby enable forming thin fine-pitch wiring patterns. Further, the conductive particle layer as a composite material for forming electrical wiring patterns is on the surface of insulating resin layer, so that, in contrast to the use of metal foils, burrs do not occur at the via hole edges during laser perforating to thereby avoid the problems of burr enlargement at the via hole edges, poor adherence of resists and insufficient etching. Therefore, it is not needed to remove portions to be perforated by etching, etc. in advance. Moreover, the laser perforating can be performed with the use of laser of lower output than that of laser heretofore proposed.

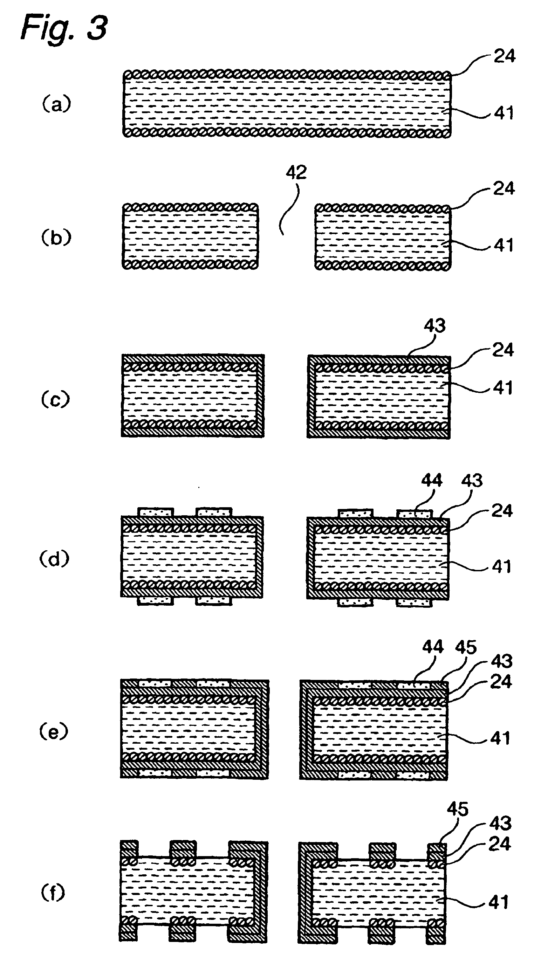

On the other hand, in the pattern plating process, the printed wiring board is produced through, for example, the process of Fig. 3. Specifically, a laminate comprising conductive particle layer 24 on surfaces of insulating resin layer 41 as shown in Fig. 3(a) is perforated by direct laser irradiation, thereby forming via holes 42 as shown in Fig. 3(b). Referring now to Fig. 3(c), electroless plating is applied to all the surfaces including via hole insides to thereby form plating layer 43. Then, referring to Fig. 3(d), resists 44 are provided so as to have patterns corresponding to gaps or spaces of the wiring patterns to be formed. Subsequently, referring to Fig. 3(e), circuits 45 of given thickness are formed by electroplating. Thereafter, the surface resists 44 are removed, and all the surfaces are etched so that especially the electroless plating layers 43 and conductive particle layer 24 at noncircuit portions are removed (this may be referred to as "flash etching") to thereby obtain circuits 45 as shown in Fig. 3(f). In this process, solder plating of tin, lead or the like may be applied to surfaces of the wiring patterns prior to resist removal.

Both the above panel plating process and pattern plating process enable producing a printed wiring board which is excellent in the adherence of the wiring pattern layers to insulating resin and also in heat resistance.

Furthermore, in the present invention, a multilayer printed wiring board can be obtained by providing the above printed wiring board for use as a substrate with inner layer circuits; bonding it, through an insulating resin layer, with the composite foil of the present invention; removing the conductive carrier; disposing the conductive particle layer on the surface of insulating resin layer; forming via holes and wiring patterns; and plating.

The number of layers of the multilayer printed wiring board can be increased by repeating this operation.

The formation of a copper-clad laminate from the composite foil of the present invention enables one to dispose an extremely thin conductive particle layer on a surface of insulating resin layer, so that the problem of burrs occurring at the perforating of copper-clad laminate by insulating resin layer drilling, laser perforating or similar means can be solved. Further, the laser perforating can be performed with the use of laser of lower output than that of lasers heretofore proposed. Still further, the use of the above composite foil of the present invention enables reducing the thickness of wiring patterns, so that printed wiring boards having fine-pitch wiring patterns can be produced with high efficiency. Still further, the use of the above composite foil of the present invention enables realizing satisfactory bonding strength between the insulating resin layer and the wiring patterns.

The present invention will now be illustrated in greater detail with reference to the following Examples, which in no way limit the scope of the invention.

### EXAMPLE 1

Electrolytic copper foil of 35 µm thickness was provided as a conductive carrier, and its shiny side was immersed in a 10 g/liter aqueous solution of carboxybenzotriazole at 40°C for 30 sec so that an organic release layer was formed on the surface of the carrier copper foil.

Subsequently, the surface of the thus formed organic release layer was washed with water and subjected to cathodic electrolysis. The cathodic electrolysis was performed at a current density of 15 A/dm² for 7 sec in a plating bath whose temperature, copper concentration and sulfuric acid concentration were 30°C, 10 g/liter and 170 g/liter, respectively. Thus, a conductive particle layer was formed on the organic release layer.

The composite foil thus furnished with the conductive particle layer was subjected to further cathodic electrolysis. The cathodic electrolysis was performed at a current density of 30 A/dm² for 10 sec in a plating bath whose temperature, copper concentration and sulfuric acid concentration were 50°C, 75 g/liter and 80 g/liter, respectively. Thus, a covering layer was plated on the electrodeposit, and there was obtained a nodular conductive particle layer. The thickness of the resultant conductive particle layer after the formation of the covering layer was about 1.5 µm.

The thus obtained composite foil was further passivated with zinc and a chromate.

### EXAMPLE 2

Electrolytic copper foil of 35 µm thickness was provided as a conductive carrier, and its shiny side was immersed in a 10 g/liter aqueous solution of carboxybenzotriazole at 40°C for 30 sec so that an organic release layer was formed on the surface of the carrier copper foil.

Subsequently, the surface of the thus formed organic release layer was washed with water and subjected to cathodic electrolysis. The cathodic electrolysis was performed at a current density of 15 A/dm² for 7 sec in a plating bath whose temperature, copper concentration and sulfuric acid concentration were 20°C, 17 g/liter and 120 g/liter, respectively, which plating bath further contained 4 ppm of α-naphthoquinoline. Thus, a whiskery conductive particle layer (size: 0.6 µm) was formed.

After the electrodeposition of conductive particle layer, passivation was performed under the same conditions as in Example 1. Thus, a composite foil was obtained.

### EXAMPLE 3

Electrolytic copper foil of 35 µm thickness was provided as a conductive carrier, and its shiny side was immersed in a 10 g/liter aqueous solution of carboxybenzotriazole at 40°C for 30 sec so that an organic release layer was formed on the surface of the carrier copper foil.

Subsequently, the surface of the thus formed organic release layer was washed with water and subjected to cathodic electrolysis. The cathodic electrolysis was performed at a current density of 20 A/dm² for 5 sec in a plating bath whose temperature, copper concentration and sulfuric acid concentration were 40°C , 20 g/liter and 70 g/liter, respectively. Thus, a conductive particle layer was formed on the organic release layer.

The composite foil thus furnished with the electrodeposit was subjected to further cathodic electrolysis. The cathodic electrolysis was performed at a current density of 30 A/dm² for 10 sec in a plating bath whose temperature, copper concentration and sulfuric acid concentration were, 50°C, 75 g/liter and 80 g/liter, respectively. Thus, a covering layer was plated on the conductive particle layer, and there was obtained a fringed conductive particle layer. The size of the resultant conductive particle layer after the plating the covering layer was about 2.3 µm.

The thus obtained composite foil was further passivated in the same manner as in Example 1.

### EXAMPLES 4 TO 6

0.1 mm thick BT resin prepreg (produced by MITSUBISHI GAS CHEMICAL CO., INC.) was laminated with each of the composite foils obtained in Examples 1 to 3 so that the conductive particle layer of the composite foil was joined to the BT resin prepreg and pressed at 200°C under 2.5 MPa (25 kgf/cm²) for 35 min to thereby effect a lamination. With respect to each of the obtained laminates, the peel strength exerted at stripping of the copper foil as the conductive carrier from the laminate was measured in accordance with JIS C 6481. All the peel strengths exhibited by the laminates were in the range of 9 to 12 N/m (9 to 12 gf/cm).

Therefore, it was found that the composite foils obtained in Examples 1 to 3 permitted easily stripping the copper foil therefrom but exhibited appropriate bonding strengths.

Thereafter, all the laminate surface was subjected to copper electroless plating and electroplating so that a copper layer of 18 µm total thickness was formed on the laminate surface. The resultant laminates were etched so that wiring patterns of line width/line spacing = 30 µm /30 µm were formed. Etchability was satisfactory, and it was found that the obtained composite material foils were very excellent in respect of minute circuit formation.

### EXAMPLES 7 TO 9

Both sides of 0.5 mm thick FR-4 base material (R-1766 produced by Matsushita Electric Works, Ltd.) were furnished with internal-layer circuits and subjected to black oxide treatment. Composite foils produced in each of Examples 1 to 3 were stacked with the resultant I FR-4 base material interposed therebetween so that the conductive particle layers were joined to both 18 µm thick internall-layer circuit surfaces of the base material, and pressed at 180°C under 2 MPa (20 kgf/cm²) for 60 min by means of a vacuum press. The carrier copper foils were stripped off, and thus there were obtained 4-layer boards with internal-layer wiring patterns.

Via holes were formed at given positions of the conductive particle layers of each of the thus obtained 4-layer boardswith internal-layer wiring patterns by carrying out 4-shot irradiation of carbon dioxide gas laser (ML505DT manufactured by Mitsubishi Electric Corp.) under conditions such that the beam diameter, current and pulse width were 220 µm, 12 A and 50 µsec, respectively.

With respect to all the 4-layer boards with internal-layer wiring patterns, burrs and other defects were not observed at the outer-layer wiring patterns of the via hole irradiation portions.

### COMPARATIVE EXAMPLE 1

Electrolytic copper foil of 35 µm thickness was provided as a conductive carrier, and its shiny side was immersed in a 10 g/liter aqueous solution of carboxybenzotriazole at 40°C for 30 sec so that an organic release layer was formed on the surface of the carrier copper foil.

Subsequently, the surface of the thus formed organic release layer was washed with water and subjected to cathodic electrolysis. The cathodic electrolysis was performed at a current density of 30 A/dm² for 50 sec in a plating bath whose temperature, copper concentration and sulfuric acid concentration were 50°C, 80 g/liter and 70 g/liter, respectively. Thus, an ultra-thin copper foil of about 6 µm thickness was formed on the organic release layer.

The surface of the thus formed ultra-thin copper foil was washed with water and subjected to cathodic electrolysis for surface roughening. The cathodic electrolysis was performed at a current density of 15A/dm² for 7 sec in a plating bath whose temperature, copper concentration and sulfuric acid concentration were 30°C, 10 g/liter and 170 g/liter, respectively. Thus, a conductive particle layer was formed on the ultra-thin copper foil. Further cathodic electrolysis was performed at a current density of 30 A/dm² for 10 sec in a plating bath whose temperature, copper concentration and sulfuric acid concentration were 50°C, 75 g/liter and 80 g/liter, respectively. Thus, a covering plating layer was formed on the conductive particle layer.

The thus obtained composite foil was further passivated with zinc and a chromate. 0.1 mm thick BT resin prepreg (produced by MITSUBISHI GAS CHEMICAL CO., INC.) was laminated with the passivated composite foil so that the ultra-thin copper foil furnished with the conductive particle layer was joined to the BT resin prepreg and pressed at 200°C under 2.5 MPa (25 kgf/cm²) for 35 min to thereby obtain a laminate. With respect to this laminate, the peel strength exerted at stripping of the copper foil as the conductive carrier from the laminate was measured in accordance with JIS C 6481. The peel strength was 10 N/m (10 gf/cm). Therefore, it was found that the obtained composite foil permitted easily stripping the carrier copper foil from the laminate but exhibited appropriate bonding strength.

4-layer board with internal-layer circuits was produced from this composite foil in the same manner as in Examples 7 to 9. Via holes were formed at given positions of the ultra-thin copper foil surface of an outer layer of the thus obtained 4-layer board with internal-layer wiring patterns by carrying out 4-shot irradiation of carbon dioxide gas laser (ML505DT manufactured by Mitsubishi Electric Corp.) under conditions such that the beam diameter, current and pulse width were 220 µm, 12 A and 50 µsec, respectively. Copper burrs were observed at the outer-layer wiring patterns of the via hole irradiation portions.

### EXAMPLE 10

Electrolytic copper foil of 35 µm thickness was provided as a conductive carrier, and its shiny side was washed with a washing liquid containing 100 g/liter of sulfuric acid for 30 sec. After the sulfuric acid washing, the copper foil was washed with purified water. The shiny side of the washed copper foil was immersed in a 5 g/liter aqueous solution of triazinethiol at 40°C for 30 sec so that an organic release layer was formed on the surface of the carrier copper foil.

Subsequently, the surface of the thus formed organic release layer was washed with water and subjected to cathodic electrolysis. The cathodic electrolysis was performed at a current density of 15 A/dm² for 8 sec in a plating bath whose temperature, copper concentration and sulfuric acid concentration were 30°C, 10 g/liter and 170 g/liter, respectively. Thus, a conductive particulate mass of copper was electrodeposited on the surface of the organic release layer. Further cathodic electrolysis was performed at a current density of 30 A/dm² for 30 sec in a plating bath whose temperature, copper concentration and sulfuric acid concentration were 50°C, 75 g/liter and 80 g/liter, respectively. Thus, a covering plating layer of copper was plated on the conductive particle layer.

The thus obtained composite material for forming electrical wiring patterns was washed with water, passivated and dried.

The thickness of the obtained conductive particle layer furnished with the covering layer was 1.0 µm measured in the direction of the thickness of the composite material for forming electrical wiring patterns.

The surface roughness (Rz) of the surface furnished with the conductive particle layer having the covering layer was 2.2 µm.

### Laminate

Each of four 0.1 mm thick FR-4 prepregs was laminated with the thus obtained composite material for forming electrical wiring patterns so that the conductive particle layer plated with the covering layer faced the prepreg, and pressed at 175°C under 2.5 MPa (25 kg/cm²) for 60 min to thereby obtain laminates.

The copper carrier was stripped off from each of the obtained laminates, and all the laminate surface was subjected to electroless plating of copper and further electroplating so that a copper layer of 35 µm total thickness was formed on the laminate surface. Thereafter, resist was provided so as to have patterns corresponding to the wiring patterns to be formed, followed by etching. Thus, evaluation samples having 10 µm wide wiring patterns were obtained. Peel strength was measured in accordance with JIS C 6481.

### Adherence

The peel strength between wiring patterns and base material (FR-4) of the obtained evaluation sample was measured and found to be 1.35x10³ N/m (1.35 kg/cm). Thus, the formed wiring patterns had satisfactory bonding strength with the base material.

### Heat resistance

The obtained evaluation sample was floated on a 160°C solder bath for 20 sec, and the peel strength between wiring patterns and base material thereof was measured.

The peel strength was 1.35x10³ N/m (1.35 kg/cm), namely no change was observed from that before the solder floating. Thus, it was demonstrated that the obtained evaluation sample had excellent heat resistance.

### Printed wiring board

Each of four 0.1 mm thick FR-4 prepregs was laminated with the above obtained composite material for forming electrical wiring patterns so that the conductive particle layer faced the prepreg, and pressed at 175°C under 2.5 MPa (25 kg/cm²) for 60 min to thereby effect bonding of the composite material for forming electrical wiring patterns and the prepreg. Thus, laminates were obtained.

The conductive carriers were removed from the laminates to thereby obtain prepregs covered with conductive particle layers. Perforating was conducted with the use of carbon dioxide gas laser. No burrs were observed at the perforated portions.

All the laminate surface was subjected to electroless plating of copper and further electroplating so that a copper layer of 18 µm total thickness was formed on the laminate surface. The resultant laminate was etched to thereby form wiring patterns of line width/line spacing = 30 µm /30 µm. Etchability was satisfactory, and hence it was found that the produced composite material was very excellent in forming minute wiring patterns.

## Claims

1. A composite foil (21) comprising:
a conductive carrier (22);
an organic release layer (23) coating a surface of the carrier (22); and
a conductive particle layer (24) formed on the organic release layer (23).

2. The composite foil (21) of claim 1, wherein the conductive particle layer (24) has a surface whose surface roughness (Rz) is in the range of 0.5 to 10.0 *µ*m.

3. The composite foil (21) of claim 1, wherein the conductive particle layer (24) has its surface plated with a covering layer.

4. The composite foil (21) of any one of claims 1 to 3, wherein the conductive particle layer (24) is composed of copper or a copper alloy.

5. The composite foil (21) of any preceding claim, wherein the conductive particle layer (24) has a thickness ranging from 0.1 to 5.0 *µ*m.

6. The composite foil (21) of any preceding claim, wherein the carrier (22) is composed of a copper foil or a copper alloy foil.

7. The composite foil (21) of any preceding claim, wherein the organic release layer (23) is composed of at least one organic compound selected from the group consisting of nitrogen-containing compounds, sulfur-containing compounds and carboxylic acids.

8. The composite foil (21) of any preceding claim, wherein the conductive particle layer (24) is composed of fringed, nodular or whiskery conductive fine particles.

9. A process tor producing a composite foil (21), comprising the steps of:
forming an organic release layer (23) on a surface of a conductive carrier (22), and
electrodepositing a conductive particle layer (24) on the organic release layer (23) with the use of a plating bath through which current is passed at a density of 10 to 50 A/dm².

10. The process of claim 9, wherein the carrier (22) is a copper foil or a copper alloy foil.

11. The process of either claim 9 or claim 10, wherein the organic release layer (23) is composed of at least one organic compound selected from the group consisting of nitrogen-containing compounds, sulfur-containing compounds and carboxylic acids.

12. The process of any one of claims 9 to 11, wherein the conductive particle layer (24) is composed of particles having a fringed, nodular or whiskery shape.

13. A copper-clad laminate comprising a composite foil (21) of any one of claims 1 to 8 laminated to an insulating resin substrate (31).

14. The copper-clad laminate of claim 13 from which the carrier (22) has been removed.

15. A process for producing a printed wiring board comprising the steps of:
(a) electrodepositing conductive fine particles on a conductive carrier (22) through an organic release layer (23) to form a conductive particle layer (24);
(b) laminating a product of (a) to at least one surface of an insulating resin substrate (31) with the conductive particle layer (24) facing said insulating resin substrate (31),
(c) removing the carrier (22) from said laminated product of (b) and leaving said conductive particle layer (24) on said insulating resin substrate (31);
(d) forming a printed wiring board on the insulating resin substrate (31) produced in step (c) by a panel plating process or a pattern plating process.

## Patentansprüche

1. Verbundfolie (21), umfassend;
einen leitfähigen Träger (22);
eine organische Trennschicht (23), die eine Oberfläche des Trägers (22) bedeckt; und
eine auf der organischen Trennschicht (23) ausgebildete Schicht (24) aus leitfähigen Teilchen.

2. Verbundfolie (21) nach Anspruch 1, wobei die Schicht (24) aus leitfähigen Teilchen eine Oberfläche aufweist, deren Oberflächenrauigkeit (Rz) im Bereich von 0,5 bis 10,0 µm liegt.

3. Verbundfolie (21) Anspruch 1, wobei die Oberfläche der Schicht (24) aus leitfähigen Teilchen mit einer Deckschicht plattiert ist.

4. Verbundfolie (21) nach einem der Ansprüche 1 bis 3, wobei die Schicht (24) aus leitfähigen Teilchen aus Kupfer oder einer Kupferlegierung besteht.

5. Verbundfolie (21) nach einem der vorhergehenden Ansprüche, wobei die Schicht (24) aus leitfähigen Teilchen eine Dicke im Bereich von 0,1 bis 5,0 µm aufweist.

6. Verbundfolie (21) nach einem der vorhergehenden Ansprüche, wobei der Träger (22) aus einer Kupferfolie oder einer Folie einer Kupferlegierung besteht.

7. Verbundfolie (21) nach einem der vorhergehenden Ansprüche, wobei die organische Trennschicht (23) aus wenigstens einer organischen Verbindung besteht, die unter stickstoffhaltigen Verbindungen, schwefelhaltigen Verbindungen und Carbonsäuren ausgewählt ist.

8. Verbundfolie (21) nach einem der vorhergehenden Ansprüche, wobei die Schicht (24) aus leitfähigen Teilchen aus unregelmäßig begrenzten, kugeligen oder nadelartigen leitfähigen feinen Teilchen besteht.

9. Verfahren zur Herstellung einer Verbundfolie (21), bei dem man:
eine organische Trennschicht (23) auf einer Oberfläche eines leitfähigen Trägers (22) ausbildet, und
auf der organischen Trennschicht (23) unter Verwendung eines Galvanisierbades, durch das man Strom mit einer Dichte von 10 bis 50 A/dm² leitet, elektrolytisch eine Schicht (24) aus leitfähigen Teilchen abscheidet.

10. Verfahren nach Anspruch 9, wobei der Träger (22) eine Kupferfolie oder eine Folie einer Kupferlegierung ist.

11. Verfahren nach Anspruch 9 oder 10, wobei die organische Trennschicht (23) aus wenigstens einer organischen Verbindung besteht, die ausgewählt ist unter stickstoffhaltigen Verbindungen, schwefelhaltigen Verbindungen und Carbonsäuren.

12. Verfahren nach einem der Ansprüche 9 bis 11, wobei die Schicht (24) aus leitfähigen Teilchen aus Teilchen mit unregelmäßig begrenzter, kugeliger oder nadelförmiger Gestalt besteht.

13. Kupferkaschiertes Laminat, umfassend eine Verbundfolie (21) nach einem der Ansprüche 1 bis 8, laminiert auf ein isolierendes Harzsubstrat (31).

14. Kupferkaschiertes Laminat nach Anspruch 13, von dem der Träger (22) entfernt worden ist.

15. Verfahren zur Herstellung einer gedruckten Leiterplatte, bei dem man
(a) auf einem leitfähigen Träger (22) über einer organischen Trennschicht (23) elektrolytisch leitfähige feine Teilchen abscheidet, wobei man eine Schicht (24) aus leitfähigen Teilchen erhält;
(b) das Produkt (a) auf wenigstens eine Oberfläche eines isolierenden Harzsubstrats (31) laminiert, wobei die Schicht (24) aus leitfähigen Teilchen dem isolierenden Harzsubstrat (31) zugewandt ist;
(c) den Träger (22) vom laminierten Produkt von (b) entfernt und die Schicht (24) aus leitfähigen Teilchen auf dem isolierenden Harzsubstrat (31) belässt;
(d) auf dem in Schritt (c) hergestellten isolierenden Harzsubstrat (31) durch Panel Plating oder Pattern Plating eine gedruckte Leiterplatte ausbildet.

## Revendications

1. Feuille (21) composite comprenant :
un support (22) conducteur ;
une couche (23) organique de détachement revêtant une surface du support (22) ; et
une couche (24) conductrice de particules formée sur la couche (23) organique de détachement.

2. Feuille (21) composite suivant la revendication 1, dans laquelle la couche (24) conductrice de particules a une surface dont la rugosité (Rz) de surface est de l'ordre de 0,5 à 10,0 µm.

3. Feuille (21) composite suivant la revendication 1, dans laquelle la couche (24) conductrice de particules a sa surface revêtue d'une couche de recouvrement.

4. Feuille (21) composite suivant l'une quelconque des revendications 1 à 3, dans laquelle la couche (24) conductrice de particules est composée de cuivre ou d'un alliage de cuivre.

5. Feuille (21) composite suivant l'une quelconque des revendications précédentes, dans laquelle la couche (24) conductrice de particules a une épaisseur allant de 0,1 à 5,0 µm.

6. Feuille (21) composite suivant l'une quelconque des revendications précédentes, dans laquelle le support (22) est composé d'une feuille de cuivre ou d'une feuille d'alliage de cuivre.

7. Feuille (21) composite suivant l'une quelconque des revendications précédentes, dans laquelle la couche (23) organique de détachement est composée d'au moins un composé organique choisi dans le groupe consistant en des composés azotés, des composés soufrés et des acides carboxyliques.

8. Feuille (21) composite suivant l'une quelconque des revendications précédentes, dans laquelle la couche (24) conductrice de particules est composée de fines particules conductrices en frange, en nodule ou en trichite.

9. Procédé de production d'une feuille (21) composite, comprenant les stades dans lesquels :
on forme une couche (23) organique de détachement sur une surface d'un support (22) conducteur, et
on dépose par voie électrique une couche (24) conductrice de particules sur la couche (23) organique de détachement en utilisant un bain de dépôt dans lequel passe du courant à une densité de 10 à 50 A/dm².

10. Procédé suivant la revendication 9, dans lequel le support (22) est une feuille de cuivre ou une feuille d'alliage de cuivre.

11. Procédé suivant la revendication 9 ou la revendication 10, dans lequel la couche (23) organique de détachement est composée d'au moins un composé organique choisi dans le groupe consistant en des composés azotés, des composés soufrés et des acides carboxyliques.

12. Procédé suivant l'une quelconque des revendications 9 à 11, dans laquelle la couche (24) conductrice de particules est composée de fines particules conductrices en frange, en nodule ou en trichite.

13. Stratifié plaqué de cuivre comprenant une feuille (21) composite suivant l'une quelconque des revendications 1 à 8 appliquée à un substrat (31) isolant en résine.

14. Stratifié plaqué de cuivre suivant la revendication 13, dont le support (22) a été enlevé.

15. Procédé de production d'une plaquette à circuit imprimé comprenant les stades dans lesquels :
(a) on dépose par voie électrique de fines particules conductrices sur un support (22) conducteur à travers une couche (23) organique de détachement pour former une couche (24) conductrice de particules ;
(b) on applique un produit de (a) à au moins une surface d'un substrat (31) isolant en résine, alors que la couche (24) conductrice de particules fait face au substrat (31) isolant en resine ;
(c) on enlève le support (22) du produit stratifié de (d) et on laisse la couche (24) conductrice de particules sur le substrat (31) isolant en résine ;
(d) on forme une plaquette à circuit imprimé sur le substrat (31) isolant en résine produit au stade (c) par un procédé de dépôt de panneau ou par un procédé de dépôt de structuration.
